# EUROPÄISCHE PATENTSCHRIFT

(11) **EP 1 114 440 B1**
(45) Veröffentlichungstag und Bekanntmachung des Hinweises auf die Patenterteilung: **12.12.2007**
(21) Anmeldenummer: 99939302.8
(22) Anmeldetag: 30.08.1999
(51) Int. Cl.: H01L 21/00

(54) **VORRICHTUNG UND VERFAHREN ZUM HANDHABEN VON EINZELNEN WAFERN**
DEVICE AND METHOD FOR HANDLING INDIVIDUAL WAFERS
DISPOSITIF ET PROCEDE PERMETTANT DE MANIPULER SEPAREMENT DES PLAQUETTES

(30) Priorität: 02.09.1998 CH 179198
(43) Veröffentlichungstag der Anmeldung: 11.07.2001
(73) Patentinhaber: Tec-Sem AG, 8274 Tägerwilen (CH)
(72) Erfinder: BLATTNER, Jakob, CH-8272 Ermatingen (CH); STIBI, Reto, CH-8595 Altnau (CH)
(74) Vertreter: Klein, Friedrich Jürgen
(86) Internationale Anmeldenummer: PCT/CH1999/000400
(87) Internationale Veröffentlichungsnummer: WO 2000/014772

(56) Entgegenhaltungen:
- EP-A- 0 858 866
- WO-A-97/45861
- US-A- 5 374 147
- US-A- 5 380 137

## Beschreibung

Die Erfindung betrifft - gemäss dem unabhängigen Anspruch 1 - eine Vorrichtung bzw. - gemäss dem unabhängigen Anspruch 6 - ein Verfahren zum Handhaben von einzelnen Wafern.

Das Handhaben von Wafern, d.h. von flachen, im Wesentlichen runden, einkristallinen Siliziumscheiben, welche zur Herstellung von Halbleiterprodukten verwendet werden, geschieht in speziellen Anforderungen genügenden Rein- oder Reinsträumen, die an sich bekannt sind. Damit die Kontamination oder Verschmutzung der Waferoberflächen eliminiert oder zumindest minimiert werden kann, geschieht das Handhaben der Wafer zudem vorzugsweise automatisiert. Die Wafer werden, z.B. nach oder zwischen Reinigungsprozessen, in Magazinen gestapelt. Diese Magazine weisen normierte Abmessungen auf und können in Kassetten oder Transportboxen sicher aufbewahrt und transportiert werden. Oft liegen die Wafer mit ihrem Randbereich auf zwei zumindest annähernd horizontal verlaufenden Schienen der Magazine und bilden so einen vertikalen Waferstapel. Um solche, eine im Wesentlichen horizontale Lage einnehmenden Scheiben bzw. Wafer aus solchen Magazinen herauszunehmen bzw. darin abzulegen, wird entweder der ganze Waferstapel bewegt, oder nur einzelne, unter Umständen vorher bestimmte Wafer, werden dem Magazin entnommen oder darin eingefügt. Vorzugsweise sollte ein Wafer, nachdem er aus einem Magazin herausgenommen wurde, an einem beliebigen Ort abgelegt werden können.

Es sind Vorrichtungen zum Transportieren von einzelnen Wafern bekannt, welche einfache Greifvorrichtungen aufweisen. Solche Vorrichtungen eignen sich für den Transport von ausschliesslich im Wesentlichen vertikal orientierten, stehenden Wafern. Weitere Vorrichtungen bzw. Roboter sind bekannt, welche einen Wafer mittels Vakuum halten: Z.B. aus US 4,886,412 ist ein Roboter zum Handhaben von im Wesentlichen vertikal ausgerichteten Wafern bekannt, während aus WO 98/02906 ein Roboter zum Handhaben von im Wesentlichen horizontal ausgerichteten Wafern bekannt ist. Jeder dieser Roboter ist also im Wesentlichen auf eine Ausrichtung der Wafer fixiert, was nachteilig sein kann, weil die Anwendungsmöglichkeiten dieser Roboter limitiert sind.

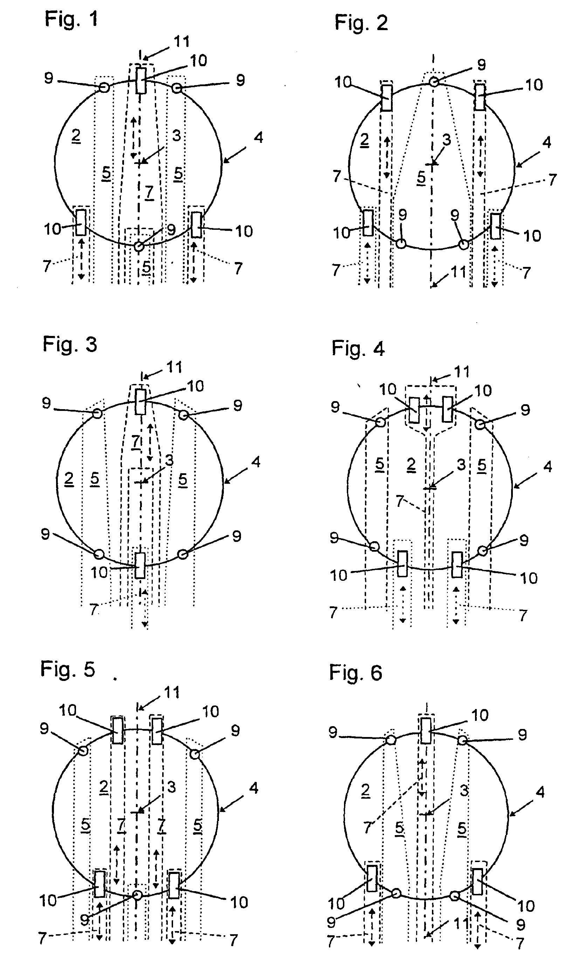

Es ist eine gattungsgemässe Vorrichtung und ein gattungsgemässes Verfahren für die Handhabung von einzelnen Siliziumscheiben bzw. Wafern, welche in Magazinen im Wesentlichen horizontal gelagert werden, aus EP 0 365 589 bekannt: Eine Einrichtung zum Transportieren einer einzelnen Siliziumscheibe mit bewegbaren, radförmigen Trägern, die relativ zueinander zwischen einer geschlossenen Position - in der ein Wafer ausschliesslich durch den Kontakt zwischen dem Umfang des Wafers und den Trägern getragen werden kann - und einer offenen Position - in der ein Wafer zwischen den Trägern angeordnet werden kann - bewegt werden können. Zur Aufnahme eines Wafers wird von zwei gegenüberliegenden Seiten je eine Unterstützung, welche zumindest zwei radförmige Träger aufweist, teilweise in ein mit Wafern gefülltes Magazin eingefahren, bis der ausgesuchte Wafer mit seinem Randbereich die radförmigen Träger an deren schiefen Auflagebereichen und an deren zylindrisch ausgebildeten Haltebereichen (vgl. Fig. 4) berührt. Der derart aufgenommene und fixierte Wafer wird durch gemeinsames, einseitiges Verfahren der beiden Unterstützungen aus dem Magazin herausbefördert. Diese Vorrichtung und dieses Verfahren haben den Nachteil, dass, falls ein Wafer aus dem Magazin herausbewegt wurde, eine der beiden Unterstützungen (die zu diesem Zweck länger ausgebildet ist) durch das Magazin hindurch reicht, so dass ein Bewegen des Wafers in eine zum Herausnehmen desselben aus dem Magazin unterschiedliche Richtung nicht möglich ist, ohne dass der Wafer von einem weiteren Transferroboter, wie er z.B. aus US 4,923,054 bekannt ist und dessen Greifmechanismus (vgl. Fig. 6) im Wesentlichen demjenigen von EP 0 365 589 entspricht, übernommen wird. Der in US 4,923,054 beschriebene Greifer eignet sich aber wegen seiner Bauhöhe nicht zum direkten Entnehmen eines zwischen zwei unmittelbaren Nachbarn liegenden Wafers aus einem gefüllten Magazin, weil er nicht zwischen zwei Wafern eines gefüllten Magazins eingefahren werden kann.

Ein weiterer Nachteil der Vorrichtung und des Verfahrens nach EP 0 365 589 könnte darin gesehen werden, dass nur Wafer aus Magazinen herausgenommen oder in diese eingelegt werden können, wenn diese Magazine vorher aus der sie schützenden Kassette herausgenommen wurden. Falls Kassetten verwendet werden, bei welchen auf einer Seite eine Durchreicheöffnung bzw. eine Türe geöffnet wird, um einen Wafer herauszunehmen, so kann diese Vorrichtung nicht eingesetzt werden.

Aus US 4,923,054 ist eine weitere Vorrichtung zum Handhaben eines Wafers bekannt, welche einen zweiarmigen Roboter umfasst, dessen vorderer Arm eine Tragplatte zum Aufliegen eines Wafers umfasst. Dieser Roboter kann aber keine vertikale Bewegung ausführen, so dass das Magazin etwas abgesenkt werden muss, damit der Roboterarm mit dem aufliegenden Wafer reibungslos aus den Tragschienen des Magazins herausgezogen werden kann. Diese Verteilung der Bewegungen auf zwei verschiedene Einrichtungen bedingt eine übergeordnete Steuerung. Zudem wird der Wafer etwa in seinem Zentrum berührt; obwohl dies natürlich auf der Rückseite des Wafers geschieht, ist damit eine gewisse Kontaminationsgefahr verbunden.

EP 0 858 866 offenbart eine weitere gattungsgemässe Vorrichtung. Diese betrifft einen mechanischen Roboterarm zum Transferieren eines Wafers. Mittels Haltefingern 102, 104 wird eine einseitige Kraft auf den Wafer 35 ausgeübt, so dass dieser gegen eine Haltebrücke 106 gedrückt wird (vgl. Fig. 3. und Fig. 5 mit den Haltefingern im geschlossenen und Fig. 7 im offenen Zustand). Auch in EP 0 858 866 wird somit offenbart, dass der Wafer eine reibende Bewegung ausführt. Diese Reibung kann mit der dort vorgeschlagenen Lösung möglicherweise reduziert aber nicht vermieden werden.

Aus US 5 380 137 ist eine weitere Vorrichtung zum Hitzebehandeln von Wafern bekannt. Diese Vorrichtung umfasst einen Arm zum Transferieren eines Wafers zwischen einem Wafermagazin ("boat 10", vgl. Fig. 1), in welchem eine Vielzahl von Wafertragplatten ("support plates 11", vgl. Fig. 2) vertikal mit regelmässigen Zwischenräumen gestapelt sind, und einer Kassette ("cassette 50", vgl. Fig. 4), in der die Wafer ebenfalls vertikal mit regelmässigen Zwischenräumen gestapelt werden sollen. Ein Waferhebemechanismus ("push up mechanism 20, 21") und eine Tragegabel ("fork 31") arbeiten zusammen. Dabei weist die Tragegabel 31 eine Aussparung 65 auf damit es nicht beim Einfahren in einen Stapel zu einer Kollision mit dem auf der Einfahrachse stehenden und mit dem Hebemechanismus 21 verbundenen Tragstift 22 kommt (vgl. Fig. 15). Mit dieser Vorrichtung können Wafer nur horizontal liegend transportiert und vertikal gestapelt werden.

Eine weitere gattungsgemässe Vorrichtung für die Handhabung von einzelnen flachen Glassubstraten bei der Herstellung von LCD-Disolays aber auch von Wafern ist aus US 5 374 147 bekannt. Die Vorrichtung zum Transferieren eines LCD-Substrates in einer Unterdruckatmosphäre umfasst einen ersten Tisch, auf dem das LCD-Substrat so befestigt ist, dass dessen Oberfläche im Wesentlichen horizontal ausgerichtet ist. Das Substrat wird auf den Tisch oder auf vorzugsweise vorgesehene Auflageelemente aus Silikongummi gelegt und mittels Halteelementen (welche unbeweglich sind oder das Substrat zwischen sich klemmen können) positioniert. Die offenbarte Vorrichtung ermöglicht das Halten und Transportieren von Substraten in ausschliesslich horizontaler Lage.

Die Aufgabe der vorliegenden Erfindung besteht darin, eine Vorrichtung und ein Verfahren zum Handhaben von Wafern vorzuschlagen, die es ermöglichen, einzelne, im Wesentlichen horizontal, insbesondere in einem Magazin, liegende Wafer im Wesentlichen reibungsfrei aufzunehmen und in praktisch beliebiger Lage zu transportieren bzw. abzulegen.

Gelöst wird diese Aufgabe gemäss einem ersten Aspekt mit den Merkmalen des unabhängigen Anspruchs 1. Bevorzugte Weiterbildungen der erfindungsgemässen. Vorrichtung ergeben sich aus den abhängigen Ansprüchen 2 bis 5.

Gemäss einem zweiten Aspekt wird diese Aufgabe mit den Merkmalen des unabhängigen Anspruchs 6 gelöst. Bevorzugte Weiterbildungen des erfindungsgemässen Verfahrens ergeben sich aus den abhängigen Ansprüchen 7 bis 12.

Bevorzugte Ausführungsformen der Erfindung sind in den Figuren mehr oder weniger schematisiert und als Beispiele dargestellt, die den Umfang der vorliegenden Erfindung keineswegs einschränken sollen. Dabei zeigen:
- Fig. 1 bis 6: Schematische Verteilungsbilder von Aufliegepunkten und Haltepunkten:
- Fig. 1: 3 Aufliegepunkte und 3 Haltepunkte, gemäss einer ersten Ausführungsform;
- Fig. 2: 3 Aufliegepunkte und 4 Haltepunkte, gemäss einer zweiten Ausführungsform;
- Fig. 3: 4 Aufliegepunkte und 2 Haltepunkte, gemäss einer dritten Ausführungsform;
- Fig. 4: 4 Aufliegepunkte und 4 Haltepunkte, gemäss einer vierten Ausführungsform;
- Fig. 5: 3 Aufliegepunkte und 4 Haltepunkte, gemäss einer fünften Ausführungsform;
- Fig. 6: 4 Aufliegepunkte und 3 Haltepunkte, gemäss einer sechsten Ausführungsform;

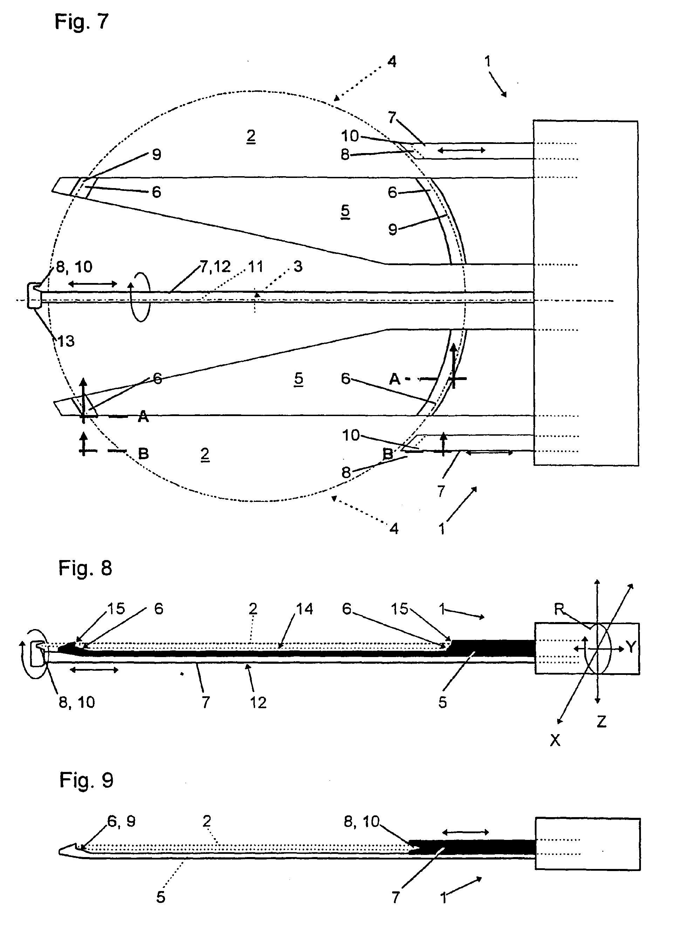

- Fig. 7: Draufsicht auf eine erfindungsgemässe Vorrichtung, gemäss einer sechsten Ausführungsform in Fig. 6;
- Fig. 8: Ansicht durch die Vorrichtung, gemäss der Schnittlinie A--A in Fig. 7;
- Fig. 9: Ansicht durch die Vorrichtung, gemäss der Schnittlinie B--B in Fig. 7.

Die Figuren 1 bis 6 zeigen einen Wafer 2 mit einem Zentrum 3 und einem Rand 4 sowie einer Achse 11, welche durch das Zentrum 3 des Wafers 2 verläuft. Von einer Vorrichtung 1 zum Handhaben eines Wafers 2 sind stark schematisiert Aufliegeteile 5 mit Aufliegebereichen 6 und Halteteile 7 mit Haltebereichen 8 dargestellt, wobei die Aufliegebereiche 6 Aufliegepunkte 9 (als Kreise dargestellt) und die Haltebereiche 8 Haltepunkte 10 (als Rechtecke dargestellt) umfassen. Weil es in diesen Skizzen hauptsächlich um die prinzipielle Verteilung der Aufliege- und Haltepunkte 9, 10 geht, sind die Aufliegeteile 5 und die Halteteile 7 nur gestrichelt gezeichnet; dies soll zudem verdeutlichen, dass es sich hier nur um Vorschläge zu Ausführungsformen dieser Aufliege- und Halteteile 5, 7 und nicht um ganz bestimmte Konstruktionen handelt. Während alle Aufliegeteile 5 mit den Aufliegebereichen 6 und den Aufliegepunkten 9 zueinander unbeweglich angeordnet sind, können die Halteteile 7 mit den Haltebereichen 8 und den Haltepunkten 10 gegeneinander und auseinander und damit auch relativ zu den Aufliegeteilen 5 mit den Aufliegebereichen 6 und den Aufliegepunkten 9 bewegt werden. Diese Bewegungen können beispielsweise in Richtung der eingezeichneten Doppelpfeile verlaufen, es können aber auch Drehbewegungen vorgesehen sein. Alle Aufliegepunkte 9 bzw. Haltepunkte 10 liegen im Bereich des Randes 4 des Wafers 2. Diese bedeutet, dass der Wafer 4 im Wesentlichen in seinem Randbereich auf den Aufliegebereichen 6 liegt und dass der Wafer 2 im Wesentlichen in seinem Randbereich von Haltebereichen 8 berührt wird.

Fig. 1 zeigt drei Aufliegepunkte 9 und drei Haltepunkte 10, gemäss einer ersten Ausführungsform der Erfindung. Dabei liegen je ein Aufliegepunkt 9 und ein Haltepunkt 10 zumindest im Wesentlichen auf der Achse 11, welche durch das Zentrum 3 des Wafers 2 verläuft. Die beiden anderen Aufliegepunkte 9 bzw. Haltepunkte 10 liegen je rechts und links, d.h. beidseits der Achse 11. Die scheinbare Unmöglichkeit der Platzierung eines Auflagepunktes 9 und eines Haltepunktes 10 auf der Achse 11 wird z.B. durch eine Gabelform des Haltebereiches 7 ermöglicht; zu diesem Zweck sind auch koaxial angeordnete und gegeneinander bzw. ineinander verschiebbare Rohre (nicht gezeigt) geeignet, wobei das äussere Rohr den Aufliegepunkt 9 und das innere, verschiebbare Rohr den Haltepunkt 10 umfasst.

Fig. 2 zeigt drei Aufliegepunkte 9 und vier Haltepunkte 10, gemäss einer zweiten Ausführungsform der Erfindung. Dabei liegt ein Aufliegepunkt 9 zumindest im Wesentlichen auf der Achse 11, welche durch das Zentrum 3 des Wafers 2 verläuft. Die beiden anderen Aufliegepunkte 9 bzw. alle Haltepunkte 10 liegen je rechts und links, d.h. beidseits der Achse 11.

Fig. 3 zeigt vier Aufliegepunkte 9 und zwei Haltepunkte 10, gemäss einer dritten Ausführungsform der Erfindung. Dabei liegt kein Aufliegepunkt 9, aber beide Haltepunkte 10 im Wesentlichen auf der Achse 11, welche durch das Zentrum 3 des Wafers 2 verläuft. Alle Aufliegepunkte 9 liegen entweder rechts oder links, d.h. beidseits der Achse 11. Die scheinbare Unmöglichkeit der Platzierung zweier Haltepunkte 10 auf der Achse 11 wird z.B. durch eine Gabelform des einen Haltebereiches 7 ermöglicht; zu diesem Zweck sind auch koaxial angeordnete und gegeneinander verschiebbare Rohre (nicht gezeigt) geeignet, wobei das äussere und das innere Rohr verschiebbar ausgebildet sind und je einen Haltepunkt 10 umfassen.

Fig. 4 zeigt vier Aufliegepunkte 9 und vier Haltepunkte 10, gemäss einer vierten Ausführungsform der Erfindung. Dabei liegen alle Aufliegepunkt 9 bzw. alle Haltepunkte 10 je rechts und links, d.h. beidseits der Achse 11. Alternativ zu dieser Darstellung können die beiden Haltepunkte 10, welche sich auf dem gleichen Halteteil 7 befinden, als ein gemeinsamer Haltepunkt 10 ausgebildet sein, so dass nur noch drei Haltepunkte vorgesehen sind. In diesem Falle würde der gemeinsame Haltepunkt 10 vorzugsweise auf der durch das Zentrum 3 des Wafers 2 gehenden Achse 11 liegen.

Fig. 5 zeigt drei Aufliegepunkte 9 und vier Haltepunkte 10, gemäss einer fünften Ausführungsform der Erfindung. Dabei liegt ein Aufliegepunkt 9 zumindest im Wesentlichen auf der Achse 11, welche durch das Zentrum 3 des Wafers 2 verläuft.

Die beiden anderen Aufliegepunkte 9 bzw. alle Haltepunkte 10 liegen je rechts und links, d.h. beidseits der Achse 11. Alternativ zu dieser Darstellung können die beiden Haltepunkte 10, welche sich auf den Halteteilen 7 befinden, die am nächsten der Achse 11 verlaufen, als ein gemeinsamer Haltepunkt 10 ausgebildet sein, so dass nur noch drei Haltepunkte vorgesehen sind. In diesem Falle würde der gemeinsame Haltepunkt 10 vorzugsweise auf der durch das Zentrum 3 des Wafers 2 gehenden Achse 11 liegen. Die scheinbare Unmöglichkeit der Platzierung eines Auflagepunktes 9 und eines gemeinsamen Haltepunktes 10 auf der Achse 11 kann z.B. durch eine Gabelform des gemeinsamen, inneren Haltebereiches 7 ermöglicht werden; zu diesem Zweck sind auch koaxial angeordnete und gegeneinander verschiebbare Rohre (nicht gezeigt) geeignet, wobei das äussere Rohr den Aufliegepunkt 9 und das innere, verschiebbare Rohr den Haltepunkt 10 umfasst.

Fig. 6 zeigt vier Aufliegepunkte 9 und drei Haltepunkte 10, gemäss einer sechsten Ausführungsform der Erfindung. Dabei liegt ein Haltepunkt 10 im Wesentlichen auf der Achse 11, die durch das Zentrum 3 des Wafers 2 verläuft. Alle Aufliegepunkte 9 bzw. alle weiteren Haltepunkte 10 sind je rechts und links, d.h. beidseits der Achse 11 angeordnet.

Fig. 7 zeigt eine erste Variante der sechsten Ausführungsform, gemäss Fig. 6. Koaxial zur Achse 11, welche durch das Zentrum 3 des Wafers 2 verläuft, ist ein Halteteil 7 als drehbarer Stab 12 mit einem Kopf 13 angeordnet. Der Stab 12 kann entlang des Doppelpfeils bewegt werden, so dass sich der Kopf 13 dem Rand 4 des Wafers 2 nähert oder sich davon entfernt. Auf einer Seite weist der Kopf 13 eine Ausnehmung auf, welche die Haltebereiche 8 umfasst. Damit diese Haltebereiche 8 so ausgerichtet werden können, dass sie gerade den Rand 4 des Wafers 2 berühren und den Wafer 2 damit halten, kann der Stab 12 in Pfeilrichtung oder entgegengesetzt dazu gedreht werden. Ebenfalls in den Richtungen des Doppelpfeils beweglich angeordnet sind die beiden weiteren Halteteile 7, welche von der Achse 11 entfernt angeordnet sind. Auch diese Halteteile 7 weisen Haltebereiche 8 auf, welche dem Rand 4 des Wafers 2 genähert werden können. Der Wafer 2 liegt im Wesentlichen mit seinem Rand 4 auf den Aufliegebereichen 6 der Aufliegeteile 5 auf. Diese Aufliegebereiche 6 sind vorzugsweise als schiefe Ebenen ausgebildet, welche konzentrisch zum aufliegenden Wafer 2 verlaufen und gegen das Zentrum 3 des Wafers 2 geneigt sind.

Die Oberfläche der Aufliegebereiche 6 kann ein das Gleitverhalten der Wafer beeinflussendes Material umfassen. Bevorzugte solche Materialien sind Teflon^{®} bzw. Polytetrafluorethylen (PTFE, DuPont); diese bieten eine weiche Oberfläche und eine geringe Reibung an. Beschichtungen der Auflagebereiche 6 mit Hartstoffen wie z.B. Titannitrid (TiN) oder Titancarbonitrid (TiCN) ergeben eine harte, speziell abriebarme Oberfläche der Auflagebereiche 6.

Abweichend von der Darstellung in Fig. 7 kann der auf der Achse 11 angeordnete Halteteil 7 flächig ausgebildet sein und rückwärts gerichtete Haltebereiche 8 umfassen. Der so ausgebildete Halteteil 7 muss nur in den Richtungen des Doppelpfeils verschiebbar ausgebildet sein, so dass eine einfachere Konstruktion ohne Drehbewegung möglich ist.

Die Figuren 8 bzw. 9 zeigen Ansichten durch die Vorrichtung 1 zum Handhaben von einzelnen Wafern 2, gemäss den Schnittlinien A--A bzw. B--B in Fig. 7:

Die Fig. 8 zeigt einen Schnitt durch einen Aufliegeteil 5. Gut sichtbar sind hier die als schiefe Ebene ausgebildeten Aufliegebereiche 6, auf denen der Wafer 2 nur im Wesentlichen in seinem Randbereich 4 aufliegt. Der Aufliegeteil 5 ist so ausgestaltet, dass die Aufliegebereiche 6 so weit unter den Wafer 2 reichen, dass ein Zwischenraum 14 zwischen der Unterseite des Wafers 2 und der Oberseite des Aufliegeteils 5 gewährleistet ist. Ein senkrechtes oder sogar etwas rückwärts geneigtes Bord 15 begrenzt vorzugsweise ebenfalls konzentrisch die Aufliegebereiche 6, so dass - sollte ein Wafer ganz auf einer Seite der Auflagebereiche 6 liegen - der Wafer nicht aus den Auflagebereichen 6 rutschen kann und damit immer ein Zwischenraum 14 entsteht. Somit ist es nicht von Bedeutung, welche Seite des Wafers 2 gegen oben - bzw. von den Aufliegeteilen 5 weg - und welche Seite gegen unten gerichtet ist.

Die Vorrichtung 1 ist vorzugsweise an einem Arm (nicht gezeigt) befestigt und gegenüber einem Gestell (nicht gezeigt) in Pfeilrichtung oder entgegengesetzt dazu drehbar (Rotation = R), bzw. entlang allen drei Raumachsen X, Y und Z beweglich angeordnet. Zudem hat sich als vorteilhaft erwiesen, dass der Arm gegenüber dem Gestell zumindest mit einem (nicht gezeigten) Gelenk befestigt ist. Die Kombination aller dieser Freiheitsgrade erlaubt das Ausführen einer beliebigen Bewegung mit einem aufgenommenen Wafer.

Damit der Wafer 2 so gehalten ist, dass er beim Ausführen von beliebigen Bewegungen, die von der Verschiebung des Wafers in im Wesentlichen horizontaler Richtung abweichen, nicht von der Vorrichtung fallen kann, wird er von zumindest zwei Halteteilen 7 über deren Haltebereiche 8 an zumindest zwei Haltepunkten 10 gehalten. Eine mögliche Ausbildung solcher Haltebereiche 8 ist in Fig. 8 dargestellt. Dort ist ersichtlich, dass ein im Wesentlichen V-förmiger Schlitz in den Kopf 13 eingearbeitet bzw. darin ausgespart ist, so dass zwei eine "schwalbenschwanz-ähnliche" Konfiguration bildende Haltebereiche ausgebildet werden. Diese Konfiguration der sich gegenüberliegenden Haltebereiche 8 wird auch in der (nicht dargestellten) Variante mit einem verschieblich beweglichen Flachprofil (an Stelle des Drehstabes 12) bevorzugt.

Fig. 9 zeigt einen Schnitt durch einen aussen liegenden, von der Achse 11 entfernten Halteteil 7. Deutlich sichtbar ist auch hier die "schwalbenschwanz-ähnliche" Konfiguration der Haltebereiche 8. Diese ermöglichen, dass der Wafer 2 im Wesentlichen an seinem Rand 4 bzw. in seinem Randbereich gehalten wird.

Aus den Figuren ist ersichtlich, dass ein mit der Vorrichtung 1 aufgenommener und gehaltener, einzelner Wafer 2 praktisch nicht an den planen Flächen berührt werden kann. Dies ermöglicht eine extrem partikelarme Handhabung der Wafer.

Verfahren zum Handhaben von einzelnen Wafern 2, die sich zumindest zeitweise in einer im Wesentlichen horizontalen Lage befinden und die ein Zentrum 3 sowie einen Rand 4 aufweisen, werden nun im Detail anhand von Beispielen beschrieben:

### 1. Aufnehmen eines Wafers:

In einem vollständig gefüllten Magazin, das zur Aufbewahrung und zum Transport von Wafern dient, befindet sich auf allen Lagerebenen je ein Wafer. Das Magazin kann für sich allein auf einer Unterlage stehen oder es kann sich in einer Transportbox befinden, dessen Ladetüre bereits offen steht.

Eine Vorrichtung 1, welche zumindest einen Aufliegeteil 5 mit Aufliegebereichen 6 zum Aufliegen eines Wafers 2 in dessen Randbereich und zumindest einen Halteteil 7 mit Haltebereichen 8 zum Greifen des Randes 4 dieses Wafers umfasst, wobei die Aufliegebereiche 6 zumindest drei Aufliegepunkte 9 und die Haltebereiche 8 zumindest zwei Haltepunkte 10 umfassen, wird im Wesentlichen in horizontaler Richtung unterhalb des ersten, aufzunehmenden Wafers zwischen diesem Wafer und seinem nächsten Nachbarn, einem darunter angeordneten, zweiten, ebenfalls im Wesentlichen horizontal in einem Stapel liegenden Wafer 2 eingefahren. Zweckmässigerweise richtet sich deshalb die Bauhöhe des einzufahrenden Teiles der Vorrichtung 1 nach der Etagenhöhe des Wafermagazins, abzüglich einer Waferstärke und dem notwendigen Freiraum oberhalb und unterhalb der Vorrichtung, der notwendig ist, damit beim Einfahren kein Wafer berührt wird.

Nachdem die Vorrichtung 1 ganz eingefahren ist, so dass die Aufliegebereiche 6 im Wesentlichen konzentrisch zum aufzunehmenden Wafer 2 positioniert sind, wird die Vorrichtung 1, insbesondere deren Aufliegeteile 5, angehoben, bis der Wafer 2 auf den Aufliegepunkten 9 der Auflagebereiche 6 liegt und die Schienen des Magazins nicht mehr berührt.

### 2. Transportieren eines Wafers:

Mit dem aufgenommenen Wafer 2 fährt nun die Vorrichtung 1 aus dem Magazin heraus. Vor dem Ausfahren, vorzugsweise aber erst während des Ausfahrens, werden die Halteteile 7 und damit auch die Haltebereiche 8 relativ gegenüber dem Wafer 2 und damit auch gegenüber den Aufliegepunkten 9 bewegt, bis der Wafer 2 im Wesentlichen an seinem Rand 4 gehalten wird. Die "schwalbenschwanz-ähnlich" angeordneten Haltebereiche 8 mit den Haltepunkten 10 halten den Wafer so, dass er in der Vorrichtung so fixiert ist, dass er durch Bewegungen der Vorrichtung 2 beim Handhaben des Wafers 2 und auch durch beliebige, gemeinsame Lageänderungen der Vorrichtung 1 mit dem Wafer 2 unverrückbar in der Vorrichtung 1 gehalten ist.

### 3. Ablegen eines Wafers:

Ausserhalb des Wafermagazins wird der Wafer an einem beliebigen Ort, der sich sowohl auf einem wesentlich höheren oder tieferen Niveau als auch seitlich der ursprünglichen Waferposition im Magazin befinden kann, wieder in im Wesentlichen horizontaler Lage abgelegt. Selbstverständlich kann der Wafer 2 auch an seiner Ursprungsposition in einem ersten Magazin oder an einer beliebigen Position in einem zweiten Magazin abgelegt werden.

Das Ablegen eines Wafers 2 erfolgt vorzugsweise genau umkehrt wie dessen Aufnehmen, so dass bereits während des Einfahrens in im Wesentlichen horizontaler Richtung in ein Magazin die Halteteile 7 mit den Haltebereichen 8 vom Rand 4 des Wafers 2 wegbewegt werden, so dass der Wafer 2 frei auf den Aufliegepunkten 9 der Aufliegebereiche 6 liegt. Sobald der Wafer seine Ablegeposition erreicht hat, wird die Vorrichtung 1 bzw. werden die Aufliegeteile 5 mit dem Wafer 2 abgesenkt, bis er auf den Stegen bzw. Schienen des Magazins aufliegt und die Vorrichtung genügend Abstand zur unteren Oberfläche des Wafers aufweist. Darauf wird die Vorrichtung aus dem Magazin zurückgezogen bzw. aus diesem ausgefahren.

Ebenfalls möglich ist das Absetzen des Wafers 2 in im Wesentlichen vertikaler Position auf eine entsprechende Unterlage. Sogar das Auflegen eines umgedrehten Wafers 2 auf einen Flüssigkeitsfilm ist möglich.

Das Einfahren bzw. Ausfahren der einen Wafer 2 tragenden Vorrichtung 1 nimmt wegen des verhältnismässig langen Weges relativ viel Zeit in Anspruch. Das Anheben der Vorrichtung zum Aufnehmen eines Wafers bzw. das Absenken der Vorrichtung zum Ablegen eines Wafers braucht dagegen, wegen der verhältnismässig kurzen Wege, nur eine relativ kurze Zeit. Auch das Greifen bzw. Fassen eines Wafers benötigt, einerseits wegen der längeren Wege und andrerseits wegen des vorzugsweisen Einsatzes von Sensoren, welche das Regeln der Haltekraft in einem gewünschten Rahmen ermöglichen, relativ viel Zeit. Zudem verlängert eine zusätzlich auszuführende Rotationsbewegung (vgl. Fig. 8) die Zeit, bis der Wafer 2 sicher gehalten ist.

Die vorliegende Erfindung ermöglicht somit das räumliche und zeitliche Trennen von zwei Hauptfunktionen, dem Aufnehmen eines Wafers und dem Fassen bzw. Greifen zum sicheren Halten oder Freigeben bzw. Loslassen desselben. Weil also das Greifen bzw. das Loslassen zeitparallel zum Ausfahren bzw. Einfahren der Vorrichtung 1 in ein Magazin verlaufen kann, wird - wie oben beschrieben - die Prozesszeit für einen Entnahmezyklus oder einen Beladezyklus verkürzt, was - bei einer grossen Zahl zu handhabender Wafer - einen wesentlichen Kostenfaktor betrifft.

Weitere Vorteile der erfindungsgemässen Vorrichtung umfassen das sichere Halten eines Wafers. Dies erlaubt:
- das Handhaben des Wafers ausserhalb eines Magazins mit hoher Geschwindigkeit, was wiederum einen Zeitgewinn bedeutet;
- das Ablegen des Wafers in einer zumindest nahezu beliebigen Lage im Raum, was das Einsparen eines zusätzlichen "Handling-Roboters" bedeuten kann.

## Patentansprüche

1. Vorrichtung (1) zum handhaben von einzelnen Wafern (2), die sich zumindest zeitweise in einer im Wesentlichen horizontalen Lage befinden und die ein Zentrum (3) sowie einen Rand (4) aufweisen, wobei die Vorrichtung (1) zumindest einen Aufliegeteil. (5) mit Aufliegebereichen (6) zum Aufliegen eines Wafers (2) in dessen Randbereich und zumindest einen Halteteil. (7) mit Haltebereichen (8) zum Greifen des Randes (4) dieses Wafers umfasst, wobei die Aufliegebereiche (6) zumindest drei Aufliegepunkte (9) und die Haltebereiche (8) zumindest zwei Haltepunkte (10) umfassen und wobei die zumindest zwei Haltepunkte (10) relativ gegenüber den Aufliegepunkten (9) sowie - zum Fassen des Wafers (2) - gegeneinander beweglich angeordnet sind, **dadurch gekennzeichnet, dass** zumindest einer dieser Haltepunkte (10) an einem als Halteteil (7) - zum Halten des Wafers - ausgebildeten, drehbaren Stab (12) angeordnet ist, wobei sich dieser drehbare Stab (12) koaxial zu einer durch das Zentrum (3) des Wafers (2) und im Wesentlichen parallel zur Waferoberfläche verlaufenden Achse (11) erstreckt.

2. Vorrichtung nach Anspruch 1, **dadurch gekennzeichnet, dass** der drehbare Stab (12) einen Kopf (13) mit Haltebereichen (8) umfasst, die eine "schwalbenschwanz-ähnliche" Konfiguration bilden.

3. Vorrichtung nach Anspruch 1 oder 2, **dadurch gekennzeichnet, dass** die Haltebereiche (8) zumindest drei Haltepunkte (10) umfassen, wovon zwei beidseits neben der Achse (11) angeordnet sind.

4. Vorrichtung nach einem der vorhergehenden Ansprüche, **dadurch gekennzeichnet, dass** die Aufliegebereiche (6) als schiefe Ebenen ausgebildet sind.

5. Vorrichtung nach einem der vorhergehenden Ansprüche, **dadurch gekennzeichnet, dass** die Aufliegebereiche (6) ein die Reibung zwischen dem Aufliegeteil (5) und dem Wafer (2) beeinflussendes Material umfassen.

6. Verfahren zum Handhaben von einzelnen Wafern (2), die sich zumindest zeitweise in einer im Wesentlichen horizontalen Lage befinden und die ein Zentrum (3) sowie einen Rand (4) aufweisen, mit einer Vorrichtung (1), welche zumindest einen Aufliegeteil (5) mit Aufliegebereichen (6) zum Aufliegen eines Wafers (2) in dessen Randbereich und zumindest einen Halteteil (7) mit Haltebereichen (8) zum Greifen des Randes (4) dieses Wafers umfasst, wobei die Aufliegebereiche (6) zumindest drei Aufliegepunkte (9) und die Haltebereiche (8) zumindest zwei Haltepunkte (10) umfassen und wobei die zumindest zwei Haltepunkte (10) relativ gegenüber den Aufliegepunkten (9) sowie - zum Fassen des Wafers (2) - gegeneinander beweglich angeordnet sind, **dadurch gekennzeichnet, dass** der Wafer (2) durch Anheben der Aufliegebereiche (6) angehoben und durch relatives Bewegen der Haltebereiche (8) gegenüber den Aufliegebereichen (6) und durch gegeneinander Bewegen von zumindest zwei Haltepunkten (10) gehalten wird, wobei zumindest einer dieser Haltepunkte (10) an einem als Halteteil (7) ausgebildeten, drehbaren Stab (12) angeordnet ist, der sich koaxial zu einer durch das Zentrum (3) des Wafers (2) und im Wesentlichen parallel zur Waferoberfläche verlaufenden Achse (11) erstreckt.

7. Verfahren nach Anspruch 6, **gekennzeichnet durch** die folgenden Schritte:
• Einfahren der Vorrichtung (1) zwischen einen ersten und einen darunter angeordneten, zweiten, im Wesentlichen horizontal in einem Stapel liegenden Wafer (2) ;
• Anheben der Aufliegebereiche (6), bis der erste Wafer an den Aufliegepunkten (9) aufliegt und angehoben wird;
• Relatives Bewegen der Haltebereiche (8) gegenüber den Aufliegebereichen (6), bis der erste Hafer über die Haltepunkte (10) an seinem Rand (4) gehalten wird;
• Ausfahren der Vorrichtung (1) aus dem Waferstapel.

8. Verfahren nach Anspruch 7, **dadurch gekennzeichnet, dass** das Einfahren der Vorrichtung (1) in einen Stapel von vertikal geschichteten, im Wesentlichen horizontal liegenden Wafern (2) von einer Seite ausgeführt wird.

9. Verfahren nach einem der Ansprüche 6 bis 8, **dadurch gekennzeichnet, dass** das relative Bewegen der Haltebereiche (8) gegenüber den Aufliegebereichen (6) gleichzeitig und während des Ausfahrens der Vorrichtung (1) aus dem Waferstapel ausgeführt wird.

10. Verfahren nach einem der Ansprüche 6 bis 9, **dadurch gekennzeichnet, dass** der erste Wafer (2) zumindest in einer der vier möglichen Bewegungsrichtungen (X, Y, Z, R) bewegt wird.

11. Verfahren nach einem der Ansprüche 6 bis 10, **dadurch gekennzeichnet, dass** das relative Bewegen der Haltebereiche (8) gegenüber den Aufliegebereichen (6) gleichzeitig und während des Einfahrens der Vorrichtung (1) in einen Waferstapel ausgeführt wird.

12. Verfahren nach einem der Ansprüche 6 bis 11, **dadurch gekennzeichnet, dass** der erste Wafer (2) in horizontaler oder vertikaler Position abgesetzt wird.

## Claims

1. A device (1) for the manipulation of individual wafers (2), which at least temporarily are located in an essentially horizontal position, and which have a centre (3) and also an edge (4), wherein the device (1) comprises at least one supporting part (5) with supporting regions (6) to support a wafer (2) in its edge region, and at least one holding part (7) with holding regions (8) for gripping the edge (4) of this wafer, wherein the supporting regions (6) comprise at least three supporting points (9) and the holding regions (8) comprise at least two holding points (10), and wherein the at least two holding points (10) are arranged such that they can move relative to the supporting points (9) and also - to secure the wafer (2) - such that they can move relative to each other, **characterised in that** at least one of these holding points (10) is arranged on a rotatable bar (12) designed as a holding part (7) to hold the wafer, wherein this rotatable bar (12) extends coaxially to an axis (11) running through the centre (3) of the wafer (2) and essentially parallel to the wafer surface.

2. The device according to Claim 1, **characterised in that** the rotatable bar (12) comprises a head (13) with holding regions (8), which form a configuration "similar to that of a dovetail".

3. The device according to Claim 1 or 2, **characterised in that** the holding regions (8) comprise at least three holding points (10), of which two are arranged on both sides near the axis (11).

4. The device according to one of the previous claims, **characterised in that** the supporting regions (6) are designed as inclined planes.

5. The device according to one of the previous claims, **characterised in that** the supporting regions (6) comprise a material that affects the friction between the supporting part (5) and the wafer (2).

6. A method for the manipulation of individual wafers (2), which at least temporarily are located in an essentially horizontal position, and which have a centre (3) and also an edge (4), with a device (1), which comprises at least one supporting part (5) with supporting regions (6) to support a wafer (2) in its edge region, and at least one holding part (7) with holding regions (8) for gripping the edge (4) of this wafer, wherein the supporting regions (6) comprise at least three supporting points (9) and the holding regions (8) comprise at least two holding points (10), and wherein the at least two holding points (10) are arranged such that they can move relative to the supporting points (9) and also - to secure the wafer (2) - such that they can move relative to each other, **characterised in that** the wafer (2) is lifted by the lifting of the supporting regions (6) and is held by movement of the holding regions (8) relative to the supporting regions (6) and by movement relative to each other of at least two holding points (10), wherein at least one of these holding points (10) is arranged on a rotatable bar (12) designed as a holding part (7), which extends coaxially to an axis (11) running through the centre (3) of the wafer (2) and essentially parallel to the wafer surface.

7. The method according to Claim 6, **characterised by** the following steps:
- inward traverse of the device (1) between a first wafer and a second wafer (2) arranged underneath, both lying essentially horizontally in a stack;
- lifting of the supporting regions (6), until the first wafer is supported on the supporting points (9) and is lifted;
- movement of the holding regions (8) relative to the supporting regions (6), until the first wafer is held via the holding points (10) at its edge (4) .
- outward traverse of the device (1) from the wafer stack.

8. The method according to Claim 7, **characterised in that** the inward traverse of the device (1) is executed from one side into a stack of vertically layered wafers (2), lying essentially horizontally.

9. The method according to one of the Claims 6 to 8, **characterised in that** the movement of the holding regions (8) relative to the supporting regions (6) is executed at the same time and during the outward traverse of the device (1) from the wafer stack.

10. The method according to one of the Claims 6 to 9, **characterised in that** the first wafer (2) is moved in at least one of the four possible directions of movement (X, Y, Z, R).

11. The method according to one of the Claims 6 to 10, **characterised in that** the movement of the holding regions (8) relative to the supporting regions (6) is executed at the same time and during the inward traverse of the device (1) into a wafer stack.

12. The method according to one of the Claims 6 to 11, **characterised in that** the first wafer (2) is disposed in a horizontal or vertical position.

## Revendications

1. Dispositif (1) pour manipuler des tranches de silicium (2) individuelles, se trouvant au moins temporairement dans une position sensiblement horizontale et comportant un centre (3), ainsi qu'un bord (4), le dispositif (1) comprenant au moins un élément d'appui (5) avec des zones d'appui (6) pour l'appui d'une tranche de silicium (2) sur la zone de son bord et au moins un élément de retenue (7), avec des zones de retenue (8), pour agripper le bord (4) de ladite tranche de silicium, les zones d'appui (6) comprenant au moins trois points d'appui (9) et les zones de retenue (8) comportant au moins deux points de retenue (10) et les au moins deux points de retenue (10) étant disposés de façon relativement mobile par rapport aux points d'appui (9), ainsi que (pour saisir la tranche de silicium (2)), l'un par rapport à l'autre, **caractérisé en ce qu'**au moins l'un desdits points de retenue (10) est disposé sur une tige rotative (12), conçue en tant qu'élément de retenue (7) (pour le maintien de la tranche de silicium), ladite tige rotative (12) s'étendant de façon coaxiale à un axe (11) s'écoulant à travers le centre (3) de la tranche de silicium (2) et sensiblement à la parallèle de la surface de la tranche de silicium.

2. Dispositif selon la revendication 1, **caractérisé en ce que** la tige rotative (12) comprend une tête (13) avec des zones de retenue (8), formant une configuration analogue à une queue d'aronde.

3. Dispositif selon la revendication 1 ou 2, **caractérisé en ce que** les zones de retenue (8) comprennent au moins trois points de retenue (10) dont deux sont disposés de part et d'autre à côté de l'axe (11).

4. Dispositif selon l'une quelconque des revendications précédentes, **caractérisé en ce que** les zones d'appui (6) sont conçues sous la forme de plans inclinés.

5. Dispositif selon l'une quelconque des revendications précédentes, **caractérisé en ce que** les zones d'appui (6) comprennent une matière influençant le frottement entre l'élément d'appui (5) et la tranche de silicium (2).

6. Procédé pour manipuler des tranches de silicium (2) individuelles, se trouvant au moins temporairement dans une position sensiblement horizontale et comportant un centre (3), ainsi qu'un bord (4), avec un dispositif (1) comprenant au moins un élément d'appui (5) avec des zones d'appui (6) pour l'appui d'une tranche de silicium (2) sur la zone de son bord et au moins un élément de retenue (7), avec des zones de retenue (8), pour agripper le bord (4) de ladite tranche de silicium, les zones d'appui (6) comprenant au moins trois points d'appui (9) et les zones de retenue (8) comportant au moins deux points de retenue (10) et les au moins deux points de retenue (10) étant disposés de façon relativement mobile par rapport aux points d'appui (9), ainsi que (pour saisir la tranche de silicium (2)), l'un par rapport à l'autre, **caractérisé en ce que** la tranche de silicium (2) se soulève par soulèvement des zones d'appui (6) et qu'elle est maintenue par déplacement relatif des zones de retenue (8) par rapport aux zones d'appui (6) et par déplacement l'un contre l'autre d'au moins deux points de retenue (10), au moins l'un de ces points de retenue (10) étant disposé sur une tige rotative (12) conçue sur l'élément de retenue (7), qui s'étend de façon coaxiale à un axe (11) s'écoulant à travers le centre (3) de la tranche de silicium (2) et sensiblement à la parallèle de la surface de la tranche de silicium.

7. Procédé selon la revendication 6, **caractérisé par** les étapes suivantes :
- introduction du dispositif (1) entre une première et une deuxième tranche de silicium (2) disposée sous cette dernière, placées sensiblement à l'horizontale dans une pile ;
- soulèvement des zones d'appui (6), jusqu'à ce que la première tranche de silicium s'appuie sur les points d'appui (9) et soit soulevée ;
- déplacement relatif des zones de retenue (8) par rapport aux zones d'appui (6), jusqu'à ce que la première tranche de silicium soit maintenue sur son bord (4), par l'intermédiaire des points de retenue (10).
- sortie du dispositif (1) hors de la pile de tranches de silicium.

8. Procédé selon la revendication 7, **caractérisé en ce que** l'introduction du dispositif (1) dans une pile de tranches de silicium (2) empilées à la verticale, placées sensiblement à l'horizontale est réalisée à partir d'un côté.

9. Procédé selon l'une quelconque des revendications 6 à 8, **caractérisé en ce que** le déplacement relatif des zones de retenue (8) par rapport aux zones d'appui (6) est réalisé simultanément et pendant la sortie du dispositif (1) hors de la pile de tranches de silicium.

10. Procédé selon l'une quelconque des revendications 6 à 9, **caractérisé en ce que** la première tranche de silicium (2) est déplacée au moins dans l'une des quatre directions de déplacement possibles (X, Y, Z, R).

11. Procédé selon l'une quelconque des revendications 6 à 10, **caractérisé en ce que** le déplacement relatif des zones de retenue (8) par rapport aux zones d'appui (6) est réalisé simultanément et pendant l'introduction du dispositif (1) dans une pile de tranches de silicium.

12. Procédé selon l'une quelconque des revendications 6 à 11, **caractérisé en ce que** la première tranche de silicium (2) est déposée en position horizontale ou verticale.
